# EUROPEAN PATENT APPLICATION

(11) **EP 4 823 272 A1**
(43) Date of publication of application: **14.10.2026**
(21) Application number: 25209689.6
(22) Date of filing: 20.10.2025
(51) Int. Cl.: H10D 30/01, H10D 30/47, H10D 30/87, H10D 64/64, H10D 62/17, H10D 64/27, H10D 64/60, H10D 62/85

(54) **HEMT COMPRISING PITS IN THE GATE STACK AND METHOD FOR MANUFACTURING THEREOF**

(30) Priority: 09.04.2025 CN 202510439957
(71) Applicant: Enkris Semiconductor, Inc, Suzhou, Jiangsu 215125 (CN)
(72) Inventor: CHENG, Kai, Suzhou, 215125 (CN)
(74) Representative: Dai, Simin

(57) **Abstract**

The present disclosure provides a semiconductor structure, in particular a HEMT, and a method for manufacturing thereof, and the semiconductor structure includes a substrate (10), a III-Nitride channel layer (20) on the substrate and a barrier layer (30) on the channel layer; a P-type III-Nitride layer (40) in a gate region and on a side of the barrier layer away from the substrate; an insertion layer (70) on a side of the P-type layer away from the substrate; and a cap layer (50) on a side of the insertion layer away from the substrate; where a surface of the cap layer away from the substrate includes pits (51) which can change crystal planes of a contact interface between the cap layer and a gate electrode (63); and the insertion layer and the cap layer are made of different materials.

## Description

### TECHNICAL FIELD

The disclosure relates to the technical field of semiconductors, in particular to a semiconductor structure and a method for manufacturing thereof.

### BACKGROUND

Compared with the first generation semiconductor materials and the second generation semiconductor materials, the third generation semiconductor materials, especially GaN-based materials, exhibit advantages, such as wide bandgap, high breakdown electric field, high electron mobility, and strong radiation resistance; and GaN-based HEMT (High Electron Mobility Transistor) devices demonstrate significant development potential in high-frequency and high-power applications, such as wireless communication base stations, radars, automotive electronics, and so on.

GaN-based HEMT devices are typically depletion-mode field-effect transistors, but in practical applications, enhancement-mode HEMT devices are often required due to cost considerations and fault protection requirements. Conventional GaN-based HEMT devices can achieve the enhancement-mode devices using P-type gate, but processes of forming the P-type gate still face issues such as current leakage.

### SUMMARY

In view of this, a semiconductor structure and a method for manufacturing thereof are provided in embodiments of the present disclosure.

According to an aspect of the present disclosure, some embodiments of the present disclosure provide a semiconductor structure, and the semiconductor structure includes a substrate, a channel layer on the substrate and a barrier layer on the channel layer; a P-type layer in a gate region and on a side of the barrier layer away from the substrate; an insertion layer on a side of the P-type layer away from the substrate, and a cap layer on a side of the insertion layer away from the substrate, where a surface of the cap layer away from the substrate includes pits.

According to another aspect of the present disclosure, a method for manufacturing a semiconductor structure is provided in some embodiments of the present disclosure. The method for manufacturing the semiconductor structure includes: S1, epitaxially growing a channel layer and a barrier layer on a substrate sequentially; and S2, forming a P-type layer, an insertion layer, and a cap layer which are sequentially stacked on the side of the barrier layer away from the substrate in a gate region, where a surface of the cap layer away from the substrate includes pits.

Some embodiments of the present disclosure provide a semiconductor structure and a method for manufacturing thereof, and the semiconductor structure includes a substrate, a channel layer on the substrate and a barrier layer on the channel layer; a P-type layer in a gate region and on a side of the barrier layer away from the substrate; an insertion layer on a side of the P-type layer away from the substrate; and a cap layer on a side of the insertion layer away from the substrate; where a surface of the cap layer away from the substrate includes pits which can replace crystal planes of a contact interface between the cap layer and a gate electrode; the insertion layer and the cap layer are made of different materials.

### BRIEF DESCRIPTION OF DRAWINGS

FIG. 1 is a schematic structural diagram of a semiconductor structure according to some embodiments of the present disclosure.
FIG. 2 is a schematic structural diagram of another semiconductor structure according to some embodiments of the present disclosure.
FIG. 3 is a schematic structural diagram of another semiconductor structure according to some embodiments of the present disclosure.
FIG. 4 is a schematic structural diagram of another semiconductor structure according to some embodiments of the present disclosure.
FIG. 5 is a top view schematic diagram of a cap layer of a semiconductor structure according to some embodiments of the present disclosure.
FIG. 6 is a schematic structural diagram of another semiconductor structure according to some embodiments of the present disclosure.
FIG. 7 is a top view schematic diagram of a cap layer of the semiconductor structure provided in FIG. 6.
FIG. 8 is a schematic structural diagram of another semiconductor structure according to some embodiments of the present disclosure.
FIG. 9 is a top view schematic diagram of a cap layer of the semiconductor structure provided in FIG. 8.
FIG. 10 is a schematic three-dimensional structural diagram of a cap layer of a semiconductor structure according to some embodiments of the present disclosure.
FIG. 11 is a top view schematic diagram of a cap layer of a semiconductor structure according to some embodiments of the present disclosure.
FIGs. 12 to 19 are schematic diagrams of intermediate structures of a semiconductor structure in a manufacturing process according to some embodiments of the present disclosure.
FIG. 20 is a schematic structural diagram of another semiconductor structure according to some embodiments of the present disclosure.

### DETAILED DESCRIPTION

The technical solutions in the embodiments of the present disclosure will be clearly and completely described below with reference to the accompanying drawings in the embodiments of the present disclosure, and obviously, the described embodiments are only some but not all of the embodiments of the present disclosure.

To reduce the gate leakage current of the P-type gate HEMT device and improve the quality of the P-type gate HEMT device, the present disclosure provides a semiconductor structure and a method for manufacturing thereof, and the semiconductor structure includes a substrate, a channel layer on the substrate and a barrier layer on the channel layer; a P-type layer in the gate region and on a side of the barrier layer away from the substrate; an insertion layer on a side of the P-type layer away from the substrate; and a cap layer on a side of the insertion layer away from the substrate, where a surface of the cap layer away from the substrate includes pits.

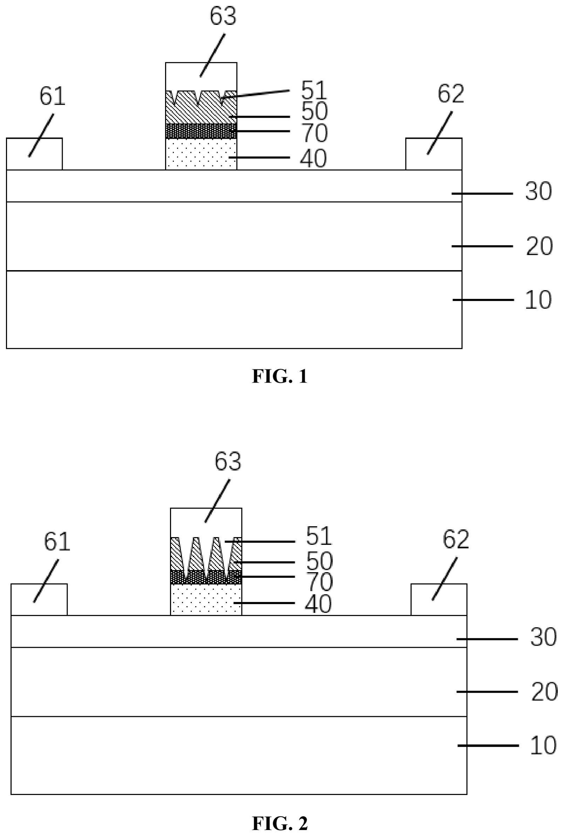

A semiconductor structure and a method for manufacturing thereof mentioned in the present disclosure are further illustrated below with examples with reference to FIGs. 1 to 11.

FIG. 1 is a schematic structural diagram of a semiconductor structure according to an embodiment of the present disclosure, and as shown in FIG. 1, the semiconductor structure includes: a substrate 10, a channel layer 20 on the substrate 10, and a barrier layer 30 on the channel layer 20; a P-type layer 40 in a gate region and on a side of the barrier layer 30 away from the substrate 10; an insertion layer 70 on a side of the P-type layer 40 away from the substrate 10; and a cap layer 50 on a side of the insertion layer 70 away from the substrate 10, where a surface of the cap layer 50 away from the substrate 10 includes pits 51. Specifically, when the crystal plane of the contact interface between the cap layer 50 and the gate electrode is the C crystal plane, the C crystal plane has a lower Schottky barrier height than other non-C crystal planes, and the pits 51 provided in the cap layer 50 can replace the C crystal plane in the contact interface between the cap layer 50 and the gate electrode by non-C crystal planes, thereby effectively improving the Schottky barrier height, reducing the gate leakage current, and improving the quality and the reliability of the device; and moreover, that the insertion layer 70 and the cap layer 50 are made of different materials can adjust the barrier height and the interface state density, thereby improving the Schottky contact characteristic, and enhancing the gate control capability.

In this embodiment, the substrate 10 may be made of sapphire, silicon carbide, silicon, GaN or diamond. Materials of the channel layer 20 and the barrier layer 30 may include Group III nitrides, and a two-dimensional electron gas (2DEG) may be formed at an interface of the channel layer 20 and the barrier layer 30.

In some embodiments, the channel layer 20 is a GaN layer and the barrier layer 30 is an AlGaN layer. In other embodiments, the material combination of the channel layer 20 and the potential barrier layer 30 may also be GaN/AIN, GaN/InN, GaN/InAlGaN, GaN/InAlN, or InN/InAlN. The material of the P-type layer 40 includes a P-type doped GaN-based material.

In some embodiments, as shown in FIG. 1, the semiconductor structure further includes: a source electrode 61 and a drain electrode 62 on the side of the barrier layer 30 away from the substrate 10, and a gate electrode 63 on a side of the cap layer 50 away from the substrate 10 and between the source electrode 61 and the drain electrode 62, where the pits are completely filled with a metal material of the gate electrode.

In some embodiments, the material of the cap layer 50 includes InGaN, AlInGaN, unintentionally doped GaN or n-type doped GaN. In some examples, when the cap layer 50 is made of InGaN or AlInGaN, V-shaped pits may be generated during the epitaxial growth of the InGaN or AlInGaN, so that the pits 51 are V-shaped pits formed by epitaxial growth, and crystal planes of inner walls of the pits 51 include (1101) crystal planes; when the cap layer 50 is made of unintentionally doped GaN or n-type doped GaN, the pits 51 may be pyramid-shaped pits or frustum-shaped pits formed by etching, and crystal planes of inner walls of the pits 51 include (1101) crystal planes or (1122) crystal planes. Specifically, the principle of forming the pits 51 may refer to the embodiment of the manufacturing method, which will not be repeated herein.

Since the surface density of the C crystal plane is generally high, a strong Fermi-level pinning effect can be generated, so that when the metal is in contact with the semiconductor, the Schottky barrier height is limited to be difficult to improve within a certain range; and the C crystal plane has the specific polarization direction and polarization strength, and when the C crystal plane is in contact with the metal gate electrode, the polarization effect will affect the electric field distribution and the charge accumulation at the interface, which results in that the Schottky barrier height can be weaken. The pits 51 are filled with metal material of the gate electrode 63 completely, and the contact interface between the cap layer 50 and the gate electrode 63 is replaced from the C crystal plane to the (1101) crystal planes or the (1122) crystal planes. On one hand, since the (1101) crystal planes or the (1122) crystal planes serve as the non-C crystal planes, the surface state density is relatively low, and the Fermi-level pinning effect is weak, when the metal gate electrode is in contact with these crystal planes, factors such as the work function of the metal and the electronic affinity of the semiconductor can more fully function, so that the Schottky barrier height is closer to the value determined by the characteristics of the metal and the semiconductor material in the ideal state, thereby achieving higher barrier height. On the other hand, the polarization property of the (1101) crystal plane or the (1122) crystal plane is different from that of the C crystal plane, the polarization direction and the polarization strength of the (1101) crystal plane or the (1122) crystal plane are more beneficial for forming an enhanced built-in electric field at the interface, and when the metal is in contact with these crystal planes, electric field distribution more beneficial for improving the barrier height can be generated, which requires electrons to overcome a higher energy barrier to transition from the semiconductor side to the metal side, thereby effectively improving the Schottky barrier height, reducing the gate leakage current, improving the gate control capability, and improving the quality and the reliability of the device.

In some embodiments, the insertion layer 70 is made of AIN or AlGaN. In some examples, the bandgap of the insertion layer 70 is greater than the bandgap of the cap layer 50. Specifically, by introducing the insertion layer 70, a higher barrier can be formed, which effectively limits the diffusion of electrons or holes under the gate electrode, reduces leakage and improves the stability of the threshold voltage. In some examples, when the insertion layer 70 contains an Al element, the insertion layer 70 can serve as an etch stop layer during the etching process of forming the pits, thereby preventing the etching process from affecting the underlying P-type layer 40.

In some embodiments, FIG. 2 is a schematic structural diagram of another semiconductor structure according to some embodiments of the present disclosure, and as shown in FIG. 2, the pits 51 penetrate through the cap layer 50 and a part of the insertion layer 70.

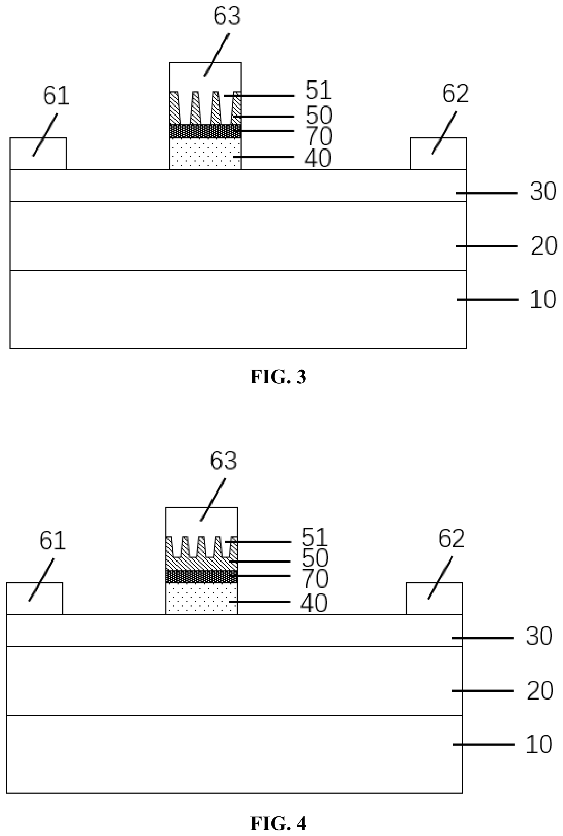

In some examples, FIG. 3 is a schematic structural diagram of another semiconductor structure according to some embodiments of the present disclosure, as shown in FIG. 3, the pits 51 penetrate through the cap layer 50 and no pit is formed in a surface of the insertion layer 70 away from the substrate 10, and in this case, a sectional shape of the pit 51 in a direction perpendicular to a plane of the substrate 10 is a trapezoid, so that a metal tip of the gate electrode 63 formed in the pit 51 can be avoided, thereby avoiding the breakdown issues caused by local enhancement of an electric field, and improving the withstand voltage capability of the device; and it avoids the alteration of the band bending characteristics of the barrier layer caused by the metal tips, thereby enhancing the gate control capability over 2DEG, and reducing the off-state leakage current.

In some examples, FIG. 4 is a schematic structural diagram of another semiconductor structure according to some embodiments of the present disclosure, as shown in FIG. 4, the pits 51 penetrate through a part of the cap layer 50, and a sectional shape of the pit 51 in a direction perpendicular to the plane of the substrate 10 is a trapezoid, so that the issues caused by the metal tip of the gate electrode 63 formed in the pit 51 can be avoided.

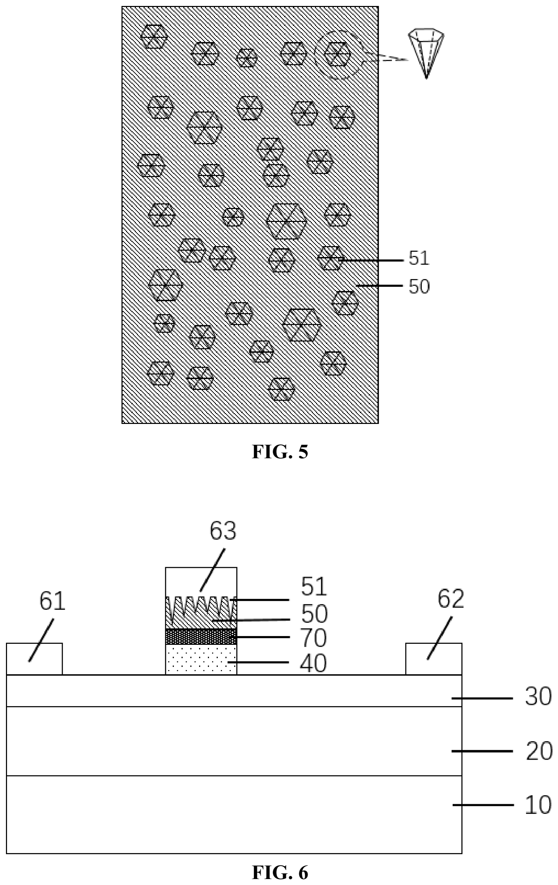

In some embodiments, FIG. 5 is a top view schematic diagram of a cap layer of a semiconductor structure according to some embodiments of the present disclosure, as shown in FIG. 5, a ratio of a total projected area of the pits 51 on a plane of the substrate 10 to a projected area of the cap layer 50 on the plane of the substrate 10 is greater than 70%. The density and the size of the pits 51 are increased, that is, the area of the C crystal plane in the cap layer 50 in contact with the metal of the gate electrode is reduced, thereby improving the Schottky barrier height, reducing the gate leakage current, and improving the quality and the reliability of the device. It can be understood that when the crystal plane of the pit is determined, the larger the depth of the pit, the larger the area of the orthographic projection of this pit on the substrate.

It should be noted that, as shown in FIG. 5, the three-dimensional structure of the pit 51 is a hexagonal pyramid shape.

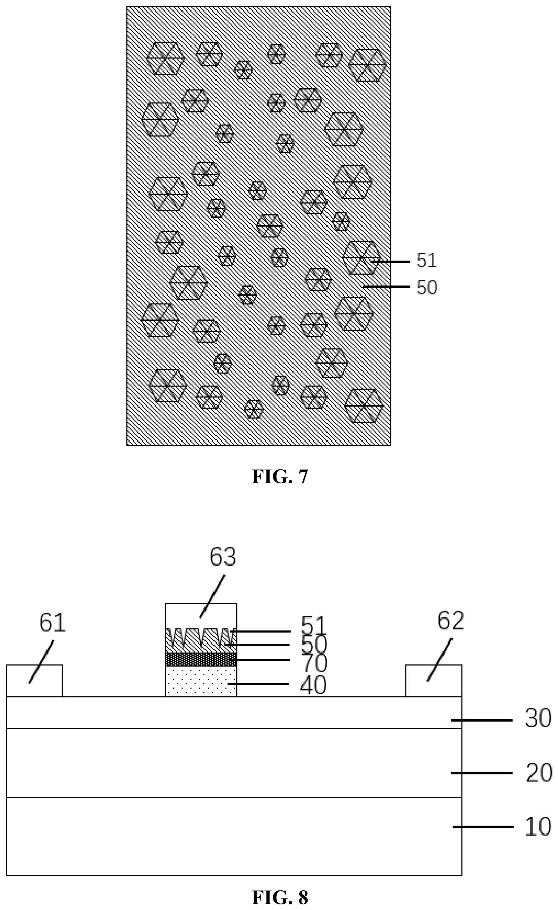

In some examples, FIG. 6 is a schematic structural diagram of another semiconductor structure according to some embodiments of the present disclosure, and FIG. 7 is a top view schematic diagram of a cap layer of the semiconductor structure provided in FIG. 6, as shown in FIGs. 6 and 7, depths of the pits 51 gradually increase from a center to an edge, the center refers to a region in the cap layer 50 away from the side wall, and an edge refers to a region in the cap layer 50 close to the side wall. The current leakage issues are more prone to occur at the sidewall of the gate region in semiconductor structures. Therefore, the depths of the pits 51 at the edge are designed to be larger, thereby reducing the possibility of sidewall leakage. Specifically, as shown in FIG. 7, compared with the center of the cap layer 50, the edge region of the cap layer 50 is provided with pits 51 with larger depths and larger orthographic projection areas on the substrate 10, that is, the area of the C crystal surface of the cap layer 50 in contact with the gate metal in the edge region is further reduced, thereby reducing the possibility of leakage current of the gate electrode sidewall, and improving the quality and the reliability of the device.

In some examples, the depth of the pits in the edge region of the cap layer close to the drain electrode is greater than the depth of the pits in the edge region of the cap layer close to the source electrode, which can reduce the area of the C crystal plane in the edge region of the cap layer close to the drain electrode and in contact with the metal of the gate electrode, and reduce the current leakage caused by the increased reverse current at the drain side.

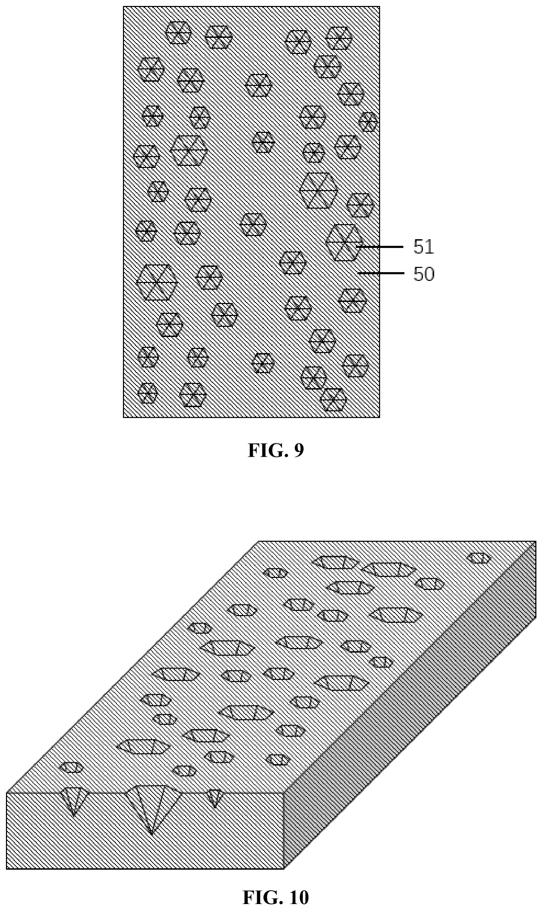

In some embodiments, FIG. 8 is a schematic structural diagram of another semiconductor structure according to some embodiments of the present disclosure, and FIG. 9 is a top view schematic diagram of a cap layer of the semiconductor structure provided in FIG. 8, as shown in FIGs. 8 and 9, projection densities of the pits 51 on a plane of the substrate 10 gradually increase from a center to an edge. The current leakage issues are more prone to occur at the sidewall of the gate region in semiconductor structures. Therefore, the density of the pits 51 at the edge are designed to be larger, thereby reducing the possibility of sidewall leakage. It should be noted that the projection areas of the pits 51 on the plane of the substrate 10 as shown in FIG. 9 are the same. Alternatively, in one semiconductor structure, the projection areas of the pits 51 on the plane of the substrate 10 are different, for example, the projection areas of the pits 51 in the edge region of the cap layer 50 are relatively larger.

In some examples, FIG. 10 is a schematic three-dimensional structural diagram of a cap layer of a semiconductor structure according to some embodiments of the present disclosure, and as shown in FIG. 10, the pits 51 are the hexagonal pyramid shape, and are randomly distributed on the upper surface of the cap layer 50 with varying depths and opening areas.

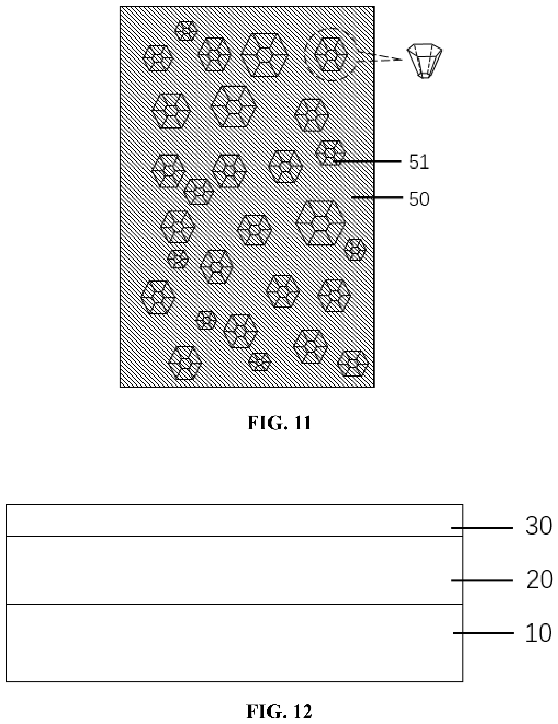

In some examples, FIG. 11 is a top view schematic diagram of a cap layer of a semiconductor structure according to some embodiments of the present disclosure, and a difference between FIG. 11 and FIG. 5 lies in that a side of the pit 51 close to the substrate 10 is a plane with a hexagon shape, the pit 51 is a hexagonal frustum, and a section of the pit 51 in a direction perpendicular to a plane of the substrate 10 is a trapezoid.

According to another aspect of the present disclosure, the present disclosure further provides a method for manufacturing a semiconductor structure. FIGs. 12 to 19 are schematic diagrams of intermediate structures of a semiconductor structure in a manufacturing process according to some embodiments of the present disclosure, and the manufacturing method includes S1 and S2.

At S1, as shown in FIG. 12, a channel layer and a barrier layer are epitaxially grown on a substrate sequentially. Materials of the channel layer 20 and the barrier layer 30 may include Group III nitrides, and a two-dimensional electron gas may be formed at an interface of the channel layer 20 and the barrier layer 30. The material of the substrate 10, as well as the material combination of the channel layer 20 and the barrier layer 30 are as described in the preceding embodiments.

At S2, a P-type layer 40, an insertion layer 70, and a cap layer 50 which are in a gate region and sequentially stacked on the side of the barrier layer 30 away from the substrate 10 are formed, where a surface of the cap layer 50 away from the substrate 10 includes pits 51.

According to the semiconductor structure manufactured by the method, the area of the C-plane crystal of the contact interface between the cap layer and the gate can be reduced, thereby improving the Schottky barrier height, reducing the gate leakage current, and improving the quality and the reliability of the device; and moreover, that the insertion layer and the cap layer are made of different materials adjusts the barrier height and the interface state density, thereby improving the Schottky contact characteristic, and enhancing the gate control capability.

In some embodiments, the material of the cap layer 50 includes InGaN, AlInGaN, unintentionally doped GaN or n-type doped GaN. When the cap layer 50 is made of InGaN or AlInGaN, V-shaped pits may be generated during the epitaxial growth of the InGaN or AlInGaN, so that the pits 51 are V-shaped pit defects formed by epitaxial growth, and crystal planes of inner walls of the pits 51 include (1101) crystal planes; when the cap layer 50 is made of unintentionally doped GaN or n-type doped GaN, the pits 51 may be pyramid-shaped pits or frustum-shaped pits formed by etching, and crystal planes of inner walls of the pits 51 include (1101) crystal planes or (1122) crystal planes.

In some embodiments, the insertion layer 70 is made of AIN or AlGaN. In some examples, the bandgap of the insertion layer 70 is greater than the bandgap of the cap layer 50.

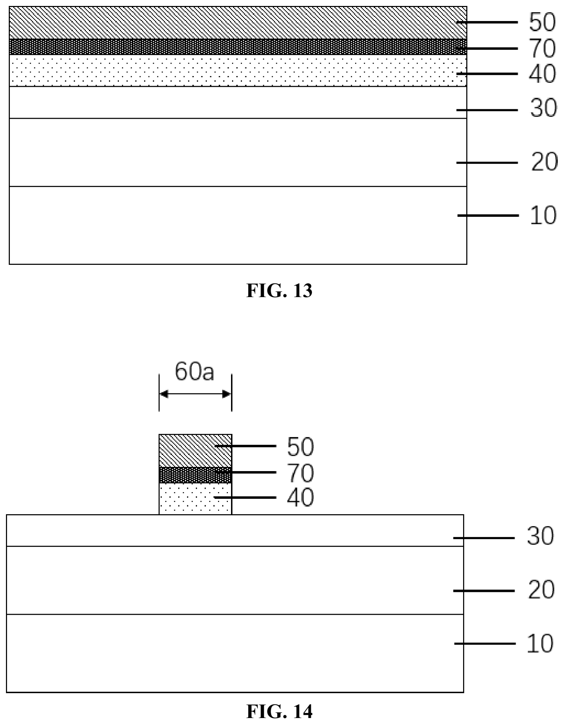

In some embodiments, taking the cap layer 50 being made of unintentionally doped GaN or n-type doped GaN as an example, forming the P-type layer 40, the insertion layer 70, and the cap layer 50 which are in the gate region and sequentially stacked on the side of the barrier layer 30 away from the substrate 10, includes: as shown in FIG. 13, growing a blanket P-type layer 40, a blanket insertion layer 70, and a blanket cap layer 50 sequentially; removing a part of the blanket P-type layer 40, the blanket insertion layer 70, and the blanket cap layer 50 outside the gate region 60a by etching.

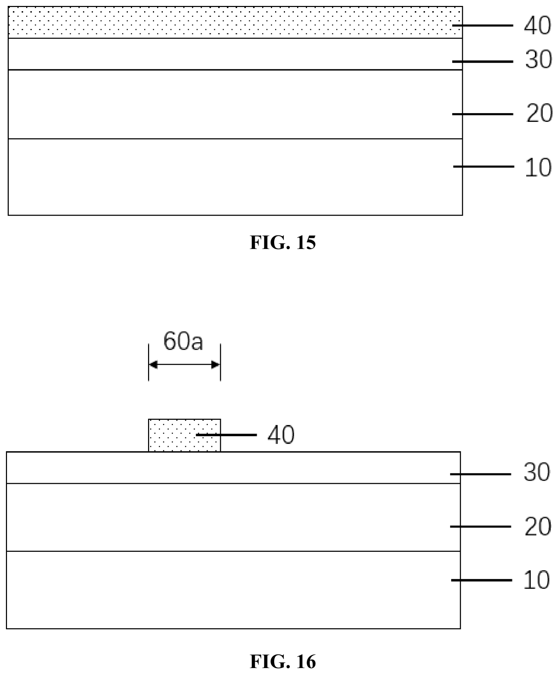

In some examples, forming the P-type layer 40, the insertion layer 70, and the cap layer 50 which are in the gate region and sequentially stacked on the side of the barrier layer 30 away from the substrate 10, includes: as shown in FIG. 15, growing a blanket P-type layer 40; as shown in FIG. 16, removing a part of the blanket P-type layer 40 outside the gate region 60a by etching to obtain the P-type layer 40; and as shown in FIG. 14, forming the insertion layer 70 and the cap layer 50 by selective epitaxy on the P-type layer in the gate region. It should be noted that during selective epitaxy, a mask layer needs to be deposited in a region outside the gate region 60a, to prevent the epitaxial insertion layer 70 and cap layer 50 from being formed outside the gate region 60a. This approach reduces steps of etching the insertion layer 70 and the cap layer 50, thereby simplifying the process.

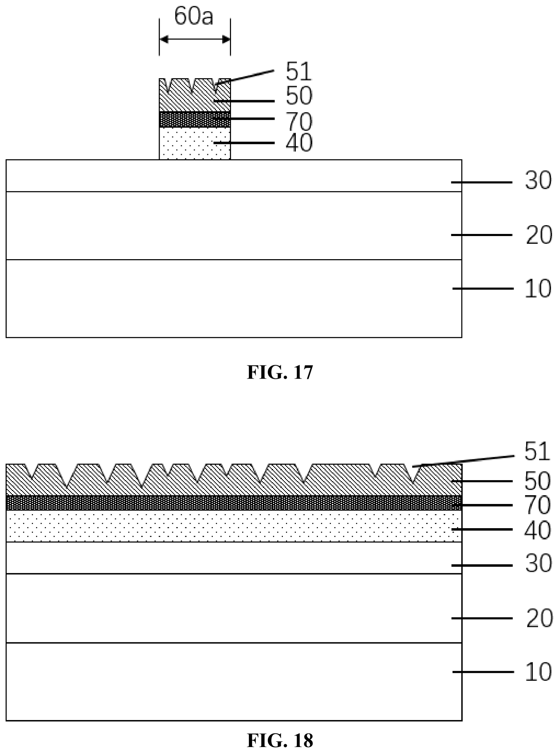

As shown in FIG. 17, after the cap layer 50 is formed, the cap layer 50 is made of unintentionally doped GaN or n-type doped GaN. The SiH₄ treatment may be performed on the surface of the material, and selective etching may be performed around the dislocation using SiH₄, to form the pyramid-shaped or frustum-shaped pits 51. The SiH₄ treatment can be performed on the surface of the blanket cap layer 50, and then a part of the cap layer 50 out of the gate region are removed by etching; or the SiH₄ treatment can be performed locally on the surface of the cap layer 50 in the gate region after etching to remove the part of the cap layer 50 outside the gate region.

In some embodiments, taking the cap layer 50 being made of InGaN or AlInGaN as an example, forming the P-type layer 40, the insertion layer 70, and the cap layer 50 which are in the gate region and sequentially stacked on the side of the barrier layer 30 away from the substrate 10, includes: as shown in FIG. 18, growing a blanket P-type layer 40, a blanket insertion layer 70 and the cap layer 50, where during the epitaxial growth of the InGaN or AlInGaN, if the material thickness exceeds the critical thickness, the material surface will form V-shaped pits to relieve strain, thereby forming the V-shaped pits 51; and as shown in FIG. 17, removing a part of the blanket P-type layer 40, a part of the insertion layer 70 and a part of the cap layer 50 outside the gate region 60a by etching.

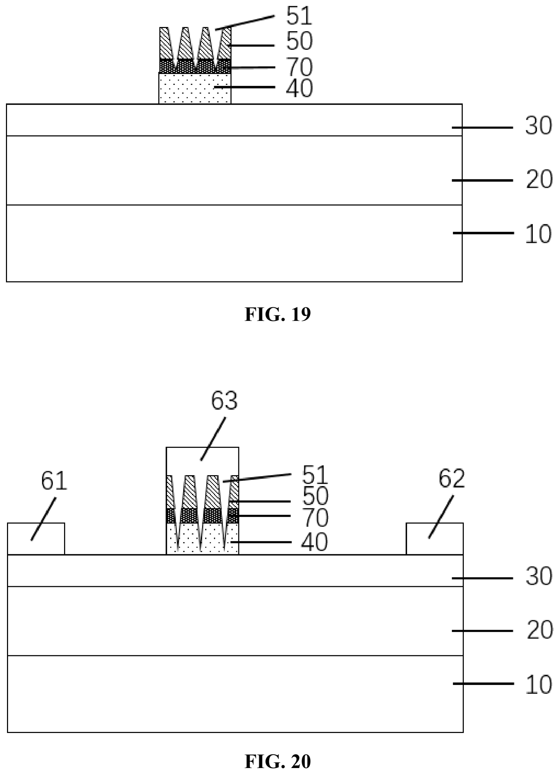

In some embodiments, as shown in FIG. 19, the pits 51 penetrate through the cap layer 50 and a part of the insertion layer 70. The pits 51 penetrate through a portion of the insertion layer 70 by etching.

In some embodiments, the manufacturing method further includes S3.

At S3, as shown in FIG. 1, a source electrode 61 and a drain electrode 62 are provided on the side of the barrier layer 30 away from the substrate 10, and a gate electrode 63 is provided on a side of the cap layer 50 away from the substrate 10 and between the source electrode 61 and the drain electrode 62, where the pits 51 are completely filled with the metal material of the gate electrode 63.

In some embodiments, FIG. 20 is a schematic structural diagram of another semiconductor structure according to some embodiments of the present disclosure, as shown in FIG. 20, the pits 51 penetrate through the cap layer 50, the insertion layer 70, and partly penetrate through the P-type layer 40, the pits 51 are filled with the gate electrode 63, and the gate electrode 63 is in direct contact with the P-type layer 40, and this three-dimensional structure expands the gate's control range over the channel both laterally and longitudinally, thereby further enhancing the depletion effect of 2DEG, reducing leakage current, and ensuring the off-state stability.

The present disclosure provides a semiconductor structure and a method for manufacturing thereof, and the semiconductor structure includes a substrate, a channel layer on the substrate and a barrier layer on the channel layer; a P-type layer in a gate region and on a side of the barrier layer away from the substrate; an insertion layer on a side of the P-type layer away from the substrate; and a cap layer on a side of the insertion layer away from the substrate; where a surface of the cap layer away from the substrate includes pits. The pits can replace the C crystal plane in the contact interface between the cap layer and the gate electrode by non-C crystal planes, thereby effectively improving the Schottky barrier height, reducing the gate leakage current, and improving the quality and the reliability of the device; and moreover, that the insertion layer and the cap layer are made of different materials can adjust the barrier height and the interface state density, thereby improving the Schottky contact characteristic, and enhancing the gate control capability.

It should be understood that the term "include" and variants thereof used in the present disclosure are open-ended, that is, "includes but is not limited to". The term "one embodiment" refers to "at least one embodiment". In this specification, the specific features, structures, materials, or characteristics described herein may be combined in any one or more embodiments or examples in an appropriate manner. Furthermore, without mutual contradiction, those skilled in the art may combine and integrate features from different embodiments or examples described in this specification, as well as combine or merge different embodiments or examples themselves.

## Claims

1. A semiconductor structure, comprising:
a substrate (10);
a channel layer (20) on the substrate (10);
a barrier layer (30) on the channel layer (20);
a P-type layer (40) in a gate region (60a) and on a side of the barrier layer away from the substrate (10);
an insertion layer (70) on a side of the P-type layer (40) away from the substrate (10); and
a cap layer (50) on a side of the insertion layer (70) away from the substrate (10);
wherein a surface of the cap layer (50) away from the substrate (10) comprises pits (51).

2. The semiconductor structure according to claim 1, wherein the insertion layer (70) is made of AIN or AlGaN.

3. The semiconductor structure according to claim 1 or 2, wherein the cap layer (50) is made of InGaN, AlInGaN, unintentionally doped GaN or n-type doped GaN.

4. The semiconductor structure according to any one of claims 1-3, wherein the pits (51) comprise:
V-shaped pits formed by epitaxial growth, or
pyramid-shaped pits or frustum-shaped pits formed by etching;
wherein crystal planes of inner walls of the pits comprise (1101) crystal planes or (1122) crystal planes.

5. The semiconductor structure according to any one of claims 1-4, wherein
the pits (51) penetrate through the cap layer (50), and no pit (51) is formed in a surface of the insertion layer (70) away from the substrate (10); or
the pits (51) penetrate through the cap layer (50) and a part of the insertion layer (70).

6. The semiconductor structure according to any one of claims 1-5, wherein a ratio of a total projected area of the pits (51) on a plane of the substrate (10) to a projected area of the cap layer (50) on the plane of the substrate (10) is greater than 70%.

7. The semiconductor structure according to any one of claims 1-6, wherein depths of the pits (51) gradually increase from a center to an edge.

8. The semiconductor structure according to any one of claims 1-7, wherein projection densities of the pits (51) on a plane of the substrate (10) gradually increase from a center to an edge.

9. The semiconductor structure according to any one of claims 1-8, further comprising:
a source electrode (61) and a drain electrode (62) on the side of the barrier layer (30) away from the substrate (10); and
a gate electrode (63) on a side of the cap layer (50) away from the substrate (10) and between the source electrode (61) and the drain electrode (62);
wherein the pits (51) are completely filled with a metal material of the gate electrode (63).

10. The semiconductor structure according to claim 9, wherein a contact interface between the cap layer (50) and the gate electrode (63) is replaced from a C crystal plane to a (1101) crystal plane or a (1122) crystal plane by providing the pits (51) in the cap layer (50).

11. The semiconductor structure according to claim 9, wherein the pits (51) comprise a first pit and a second pit which are respectively in two edge regions, the first pit is closer to the drain electrode (62) than the second pit, and a depth of the first pit is greater than a depth of the second pit.

12. A method for manufacturing a semiconductor structure, comprising:
S1: epitaxially growing a channel layer (20) and a barrier layer (30) on a substrate (10) sequentially;
S2: forming a P-type layer (40), an insertion layer (70), and a cap layer (50) which are in a gate region (60a) and sequentially stacked on a side of the barrier layer (30) away from the substrate (10) in a gate region (60a), wherein a surface of the cap layer (50) away from the substrate (10) comprises pits (51).

13. The method according to claim 12, wherein forming the P-type layer (40), the insertion layer (70), and the cap layer (50) which are in a gate region (60a) and sequentially stacked on the side of the barrier layer (30) away from the substrate (10), comprises:
growing a blanket P-type layer (40), a blanket insertion layer (70) and a blanket cap layer (50); and then removing a part of the blanket P-type layer (40), the blanket insertion layer (70) and the blanket cap layer (50) outside the gate region (60a) by etching; or
S3: growing a blanket P-type layer (40); removing a part of the blanket P-type layer (40) outside the gate region (60a) by etching to obtain the P-type layer (40); and forming the insertion layer (70) and the cap layer (50) by selective epitaxy on the P-type layer (40) in the gate region (60a).

14. The semiconductor structure according to claim 12 or 13, wherein the pits (51) comprise:
V-shaped pits formed by epitaxial growth, and crystal planes of inner walls of the V-shaped pits comprise (1101) crystal planes; or
pyramid-shaped pits or frustum-shaped pits formed by etching the cap layer (50), and crystal planes of inner walls of the pyramid-shaped pits or the frustum-shaped pits comprise (1101) crystal planes or (1122) crystal planes.

15. The method according to any one of claims 12-14, further comprising:
providing a source electrode (61) and a drain electrode (62) on the side of the barrier layer (30) away from the substrate (10); and
providing a gate electrode (62) on a side of the cap layer (50) away from the substrate (10) and between the source electrode (61) and the drain electrode (62);
wherein the pits (51) are completely filled with a metal material of the gate electrode (62).
